# EUROPEAN PATENT SPECIFICATION

(11) **EP 2 641 923 B1**
(45) Date of publication and mention of the grant of the patent: **24.05.2017**
(21) Application number: 13001446.7
(22) Date of filing: 20.03.2013
(51) Int. Cl.: C08F 212/14, C08F 212/32, H01L 51/00, H01L 31/048, C08F 12/26, C08F 12/30

(54) **(Co)-polymeric and hybrid (co)-polymeric electron acceptors for organic photovoltaic cell applications**
(Co)-Polymer- und Hybrid-(Co)-Polymer-Elektronenakzeptoren für organische photovoltaische Zellenanwendungen
Accepteurs d'électrons (co)-polymériques et hybrides (co)-polymériques pour des applications de piles photovoltaïques organiques

(30) Priority: 20.03.2012 GR 20120100166
(43) Date of publication of application: 25.09.2013
(73) Proprietor: University Of Patras, 26504 Rio Patras (GR); Foundation of Research and Technology Hellas/ Institute of Chemical Engineering Sciences (FORTH/ICE-HT), 26504 Patras (GR)
(72) Inventor: Andreopoulou, Aikaterini, 26504 Rio - Patras (GR); Kourkouli, Souzana, 26504 Rio - Patras (GR); Stefopoulos, Andreas, GR-26504 Patras (GR); Siokou, Angeliki, GR-26504 Patras (GR); Kallitsis, Ioannis, 26504 Rio, Patras (GR)
(74) Representative: Malamis, Alkisti-Irene

(56) References cited:
- SOLON P. ECONOMOPOULOS ET AL: "Novel Brush-Type Copolymers Bearing Thiophene Backbone and Side Chain Quinoline Blocks. Synthesis and Their Use as a Compatibilizer in Thiophene-Quinoline Polymer Blends", MACROMOLECULES, vol. 40, no. 4, 1 February 2007 (2007-02-01), pages 921-927, XP055052365, ISSN: 0024-9297, DOI: 10.1021/ma062055c
- ANDREAS A. STEFOPOULOS ET AL: "Polymer and Hybrid Electron Accepting Materials Based on a Semiconducting Perfluorophenylquinoline", MACROMOLECULES, vol. 43, no. 11, 8 June 2010 (2010-06-08), pages 4827-4828, XP055052366, ISSN: 0024-9297, DOI: 10.1021/ma100961y
- MAITI J ET AL: "Polythiophene based fluorescence sensors for acids and metal ions", SENSORS AND ACTUATORS B: CHEMICAL: INTERNATIONAL JOURNAL DEVOTED TO RESEARCH AND DEVELOPMENT OF PHYSICAL AND CHEMICAL TRANSDUCERS, ELSEVIER S.A, SWITZERLAND, vol. 141, no. 2, 7 September 2009 (2009-09-07), pages 447-451, XP026501691, ISSN: 0925-4005, DOI: 10.1016/J.SNB.2009.07.008 [retrieved on 2009-07-15]
- HARTMUT KRUEGER, ET AL.: "n-Type semiconducting polymers as electron acceptors for organic photovoltaics", PROC. SPIE 5520, ORGANIC PHOTOVOLTAICS V, vol. 5520, 1 November 2004 (2004-11-01), pages 98-109, XP040189906, DOI: 10.1117/12.559666

## Description

### Object of the invention

The current invention refers to the development of new copolymers with different architectures (random, block and brush) and of hybrid materials for photovoltaic systems. The synthesis and characterization of polymeric electron acceptors and copolymers which bear electron donor and electron acceptor groups is being described. We also describe the development of hybrid materials based on modified carbon allotropes with the electron acceptor polymers and donor-acceptor type copolymers which were referred above. These materials present very good solubility in common organic solvents and thus, high processability so as to create thin films, characteristics which are important prerequisites for their effective application in the active layer of organic solar cells. Also, the polymeric, copolymeric and hybrid materials exhibit optimal values of energy levels, HOMO (highest occupied molecular orbital) and LUMO (lowest unoccupied molecular orbital), that in some cases reach values even down to -3.65 eV for the LUMO level. In particular the combination of such semiconducting copolymers with carbon allotrope forms (e.g. fullerenes, carbon nanotubes and graphenes) leads to the creation of novel hybrid nanomaterials with increased processability and combined properties.

### Background of the invention

The discovery of photoinduced electron transfer between conjugated polymers and fullerene (C60) [N.S. Sariciftci, L. Smilowitz, A.J. Heeger, and F. Wudl, Science 1992, 258, 1474] as well as the optimization of photovoltaic devices using regioregular poly(3-hexylthiophene) and the soluble fullerene derivative (PCBM) (∼ 6.0% efficiency), [Marisol Reyes-Reyes, Kyungkon Kim, and David L. Carroll Appl. Phys. Lett. 2005, 87, 083506] contributed in the development of the science and research of flexible photovoltaic devices using semiconducting polymers. The requirement for further optimization of photovoltaic efficiency has drawn much research interest to the synthesis of new low band gap polymeric materials, which act as electron donors, as well as at the same time for the development for new materials with low LUMO level that act as effective electron acceptors.

The most effective electron acceptors that have been used so far in organic photovoltaic devices are soluble derivatives of fullerene (C₆₀) [Roncali, J., Acc. Chem. Res. 2009, 42, 1719]. However, further improvement of the photovoltaic efficiency is considered to be limited because of morphological constraints which appear upon mixing the polymeric electron donor and electron acceptor. More specifically, nanophase systems in the scale of 10nm are essential for the successful separation of the formed exciton in electron and hole, and for the transfer of these charges in the respective electrodes (electrones to the cathode and holes to the anode side, respectively). For this reason it is necessary to use compatibilizers of the donor acceptor system in order to achieve and stabilize the nanophase separated binary mixture. Such systems of compatibilizers may be block copolymers or brush copolymers. Also, the introduction of carbon allotrope forms acting as electron acceptors and charge carriers, in the phase of the polymeric electron acceptor can significantly increase the electron affinity of the system and contribute to the successful transfer of the electron at the cathode.

In past years, for the optimization of the polymeric part of the organic polymeric photovoltaic systems, most research groups have focused their activities mainly on the effective compatibilization and hence on the morphology of the donor-acceptor polymer system as well as on the development of even more efficient electron donors and acceptors. [T. Kietzke, H. Horhold, D. Neher Chem. Mater. 2005, 17, 6532; S. P. Economopoulos, C. L. Chochos, V. G. Gregoriou, J .K. Kallitsis, S. Barrau, G. Hadziioannou, Macromolecules, 2007, 40, 921; N. Sary, F. Richard, C. Brochon, N. Leclerc, P. Lévêque, J.-N. Audinot, S. Berson, T. Heiser, G. Hadziioannou, R. Mezzenga, Adv. Mater. 2010, 22, 763].

Poly(quinoline)s constitute one of the most promising polymeric electron accepting materials and charge carriers for different optoelectronic applications [Jenekhe, S.; Chen X. Science 1998, 279, 1903; Jenekhe S.; Chen X. Science, 1999, 283, 372]. The LUMO energy level of main chain or side quinoline bearing polymers range from -2.5eV to -4.0eV. The development of brush type copolymers, using poly(thiophene) as the main polymeric chain and poly(quinoline)s as side chains, has shown that such copolymers can be used as compatibilizers in the corresponding binary donor-acceptor systems optimizing significantly the morphology of the final blend. However, the control of the compatibilizer's energy levels is necessary in order to promote the dissociation of the formed exciton. Also, their combination with carbon allotropes (like carbon nanotubes, fullerenes and graphenes) have led to the development of hybrid materials for photovoltaic applications, but there are still constrains in their final application due to short circuiting mainly attributed to the length of the carbon nanotube. [Chochos, C. L.; Stefopoulos, A. A.; Campidelli, S.; Prato, M.; Gregoriou, V. G.; Kallitsis, J. K. Macromolecules 2008, 41, 1825; A. A. Stefopoulos, S. N. Kourkouli, S. Economopoulos, F. Ravani, A. Andreopoulou, K. Papagelis, A. Siokou, J. K. Kallitsis Macromolecules, 2010, 43, 4827].

Solon P Economopoulos et al, "Novel Brush-Type Copolymers Bearing Thiophene Backbone and Side Chain Quinoline Blocks. Synthesis and Their Use as a Compatibilizer in Thiophene-Quinoline Polymer Blends", Macromolecules, Vol. 40, no. 4, 2007 pages 921-927 discloses copolymers bearing different degrees of grafted polyquinoline segments onto a polythiophene backbone.

Andreas A. Stefopoulos et al. "Polymer and Hybrid Electron Accepting Materials Based on a Semiconducting Perfluorophenylquinoline", Macromolecules, Vol 43, no. 11, 2010, pages 4827-4828 discloses the development of hybrid CNT-poly(vinylphenyl phenylquinoline) materials.

Maiti J et al. "Polythiophene based fluorescence sensors for acids and metal ions", Sensors and Acuators B: International Journal Devoted to Research and Development of Physical and Chemical Transducers, Elsevier S.A., Vol 141, no. 2, 2009, pages 447-451, discloses fluorescence studies of poly (thiophene-3-yl-acetic acid 8-quinolinyl ester) in the presence of various species.

Hartmut Krueger, et al. "n-Type semiconducting polymers as electron acceptors for organic photovoltaics", Proc. Spie 5520, Organic Photovoltaics V, vol 5520, 2004, pages 98-109 discloses organo-soluble copolyquinoxalines in polymer blends.

Thus, it is necessary to create hybrid materials with other allotropic forms of carbon such as fullerenes, as well as new hybrid architectures combining the polymeric electron acceptor and the polymeric donor both simultaneously immobilized on the surface of the carbon allotrope in order to achieve the required nanophase separation.

The modification of poly(quinoline) towards the creation of novel materials with lower values of LUMO level (lowest unoccupied molecular orbital) increases significantly the electron accepting properties. Simultaneously immobilization of quinolines on the surface of carbon allotropes improves the final system's overall electron transfer capacity. Thus, new copolymers of substituted poly(quinoline)s and hybrid systems containing substituted poly(quinoline)s and carbon allotropes, are described in this present invention, aiming at the development of electron donor-acceptor systems (co)polymeric and hybrid (co)polymeric, for optoelectronic applications and mainly for organic photovoltaic applications.

### Summary of the Invention

The present invention provides hybrid materials as claimed in claims 1 and 2, compositions comprising the materials of the present invention in claims 3 and 4 and photovoltaic devices that utilize the materials of the present invention in claims 5 to 7.

### Description of Figures

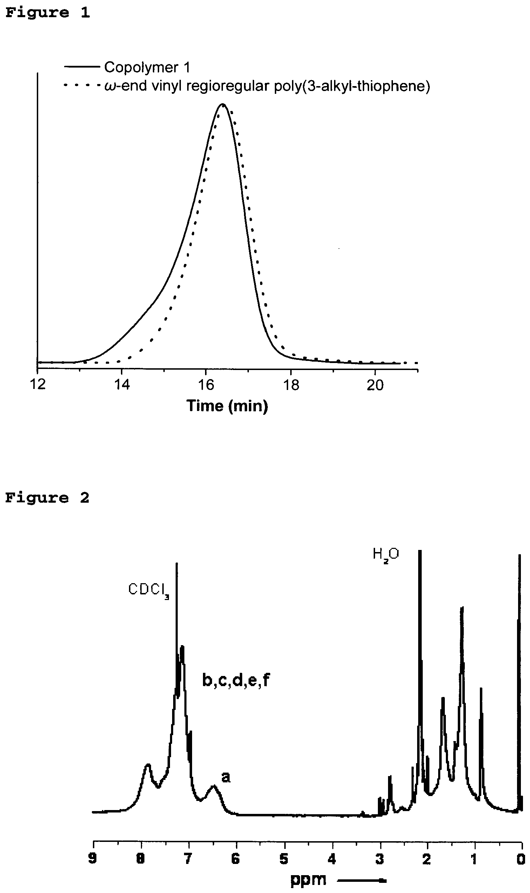

**Figure 1****:** Size exclusion chromatography for the random **Copolymer 1,** m=23, x= 1.5, y= 98.5, R1=perfluorophenyl, R2=H, R3=C₈H₁₇ in comparison with ω-end vinyl regioregular poly(3-alkyl thiophene), m=23, detection at 440nm.
**Figure 2****:** ¹H NMR spectra of the **random Copolymer 1** in CDCl₃ (25 °C), m=23, x=1.5, y=98.5, R1= perfluorophenyl, R2=H, R3=C₈H₁₇.

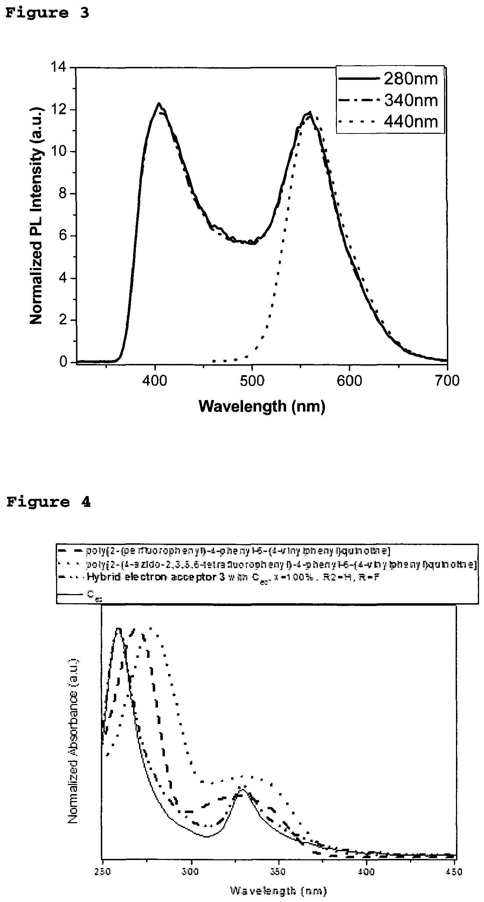

**Figure 3****:** Photoluminescence spectra in chloroform solution for the **random Copolymer 1** m=23, x=1.5, y=98.5, R1= perfluorophenyl, R2=H, R3=C₈H₁₇, after excitation at different wavelengths.
**Figure 4****:** Ultraviolet-visible absorption spectra in chloroform solution for the **Hybrid electron acceptor 3** (included by way of reference only) **x =100%,** where fullerenes have been used as carbon allotropes and, R2=H, R=F. For comparison, the respective spectra of the poly[2-(perfluorophenyl)-4-phenyl-6-(4-vinylphenyl)quinoline] homopolymer, its azide counterpart poly[2-(4-azido-2,3,5,6-tetrafluorophenyl)-4-phenyl-6-(4-vinylphenyl)quinoline] and of the neat fullerene C₆₀ are presented.

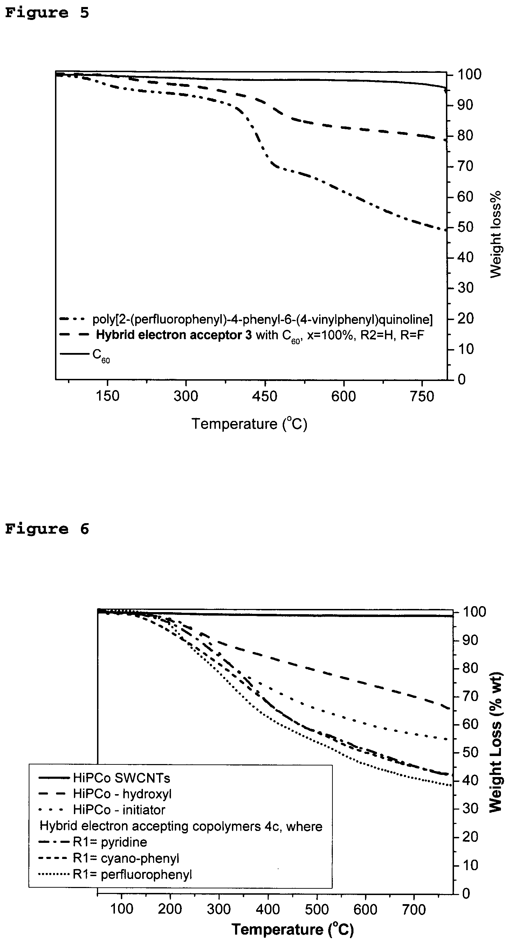

**Figure 5****:** Thermogravimetric analysis diagrams of **Hybrid electron acceptor 3** (included by way of reference only) **x=100%,** where fullerenes have been used as carbon allotropes and R2=H, R=F. For comparison, the respective diagrams of the poly[2-(perfluorophenyl)-4-phenyl-6-(4-vinylphenyl)quinoline] homopolymer, and of the neat fullerene C₆₀ are presented.
**Figure 6****:** Thermogravimetric analysis diagrams of **Hybrid electron accepting copolymers 4c,** where single wall carbon nanotubes have been used as carbon allotropes and x=5 or x=6, y=0, R1=perfluorphenyl, cyano-phenyl, pyridine and R2=H as well as TGA diagrams of initial carbon nanotubes modified with hydroxy groups, carbon nanotubes modified with chloropropionyl-hydroxy phenyl and pristine carbon nanotubes are also presented.

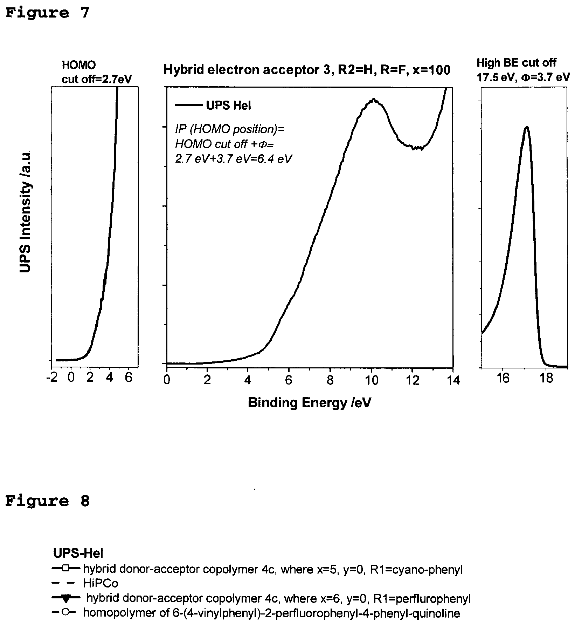

**Figure 7****:** UPS spectra of **Hybrid electron acceptor 3** (included by way of reference only)**,** fullerenes have been used as carbon allotropes and R2=H, R=F, y=0 x=100. On the left and right side, a magnified view of the area around the Fermi level and the high (binding) energy cut-off are presented, respectively.
**Figure 8****:** UPS spectra of **Hybrid donor-acceptor copolymer 4c** comprised of single wall carbon nanotubes where R2=H, R1=cyano-phenyl, x=5, y=0 or R2=H, R1=perfluorophenyl, x=6, y=0. For comparison, the respective spectra of the homopolymer of r 6-(4-vinyl phenyl)-2-perfluorophenyl-4-phenyl-quinoline and of the neat single wall carbon nanotubes, are presented.

### Detailed Description of the invention

New polymeric materials based on copolymers with modified poly(vinyl quinoline) and poly(thiophene) are described. These copolymers are random, block and brush type or hybrid copolymers bearing carbon allotropes such as fullerenes. All the described copolymers exhibit good solubility in common organic solvents, the ability to form thin films after their deposition from solution, and optimum combination of the individual components' optoelectronic properties.

More specifically, in embodiments of the present invention, the polymeric segments of the modified vinyl quinoline bear organic electron withdrawing groups such as ***R1*** = fluoro or perfluoro substituted phenyls, pyridine, cyano or nitro substituted phenyls. In this way, the reduction of the value of the lowest unoccupied molecular orbital (LUMO) of the final polymeric and copolymeric materials is achieved. The vinyl monomers of the modified quinolines in combination with vinyl substituted electron donors such as terthiophene derivatives or regioregular poly(3-alkyl thiophene) lead to the creation of random donor-acceptor type copolymers through free radical polymerization (for example **Copolymer 1**).

Furthermore, in embodiments of the present invention, for the atom transfer radical polymerization (ATRP) of the modified vinyl-quinolines and of the vinyl-terthiophenes or *ω*-end vinyl *rr*-poly(3-alkyl thiophene)s, initiator compounds are used that moreover bear additional active groups such as hydroxy or carboxy. Then the *α-*terminal hydroxy or carboxy groups of final polymeric chains react through condensation reactions and create coil-coil block electron donor-acceptor type copolymers (for example **Copolymer 2b**).

Also, in further embodiments of the present invention, rod-coil donor-acceptor type block copolymers have been synthesized by employing condensation reaction between *α*-reactive modified poly(quinoline)s and *ω*-end hydroxy regioregular poly(3-alkyl thiophene)s or terthiophenes (for example **Copolymer 2a**).

Also,, in further embodiments of the present invention, propionyl chloride groups were used as initiators, for the atom transfer radical polymerization (ATRP) of vinylic modified quinoline monomers, which were placed as side substituents in position 4 at different rates along the polymer chain of regioregular poly(3-alkyl thiophene)s. In this way brush type donor-acceptor copolymers have been developed (for example **Copolymer 2c).**

The successful development of block and brush type copolymers as well as their molecular characteristics can be detected using size exclusion chromatography (SEC). A typical SEC chromatogram for **Copolymer 1** is shown in **Figure 1**, which presents its detection at wavelength 440nm, a wavelength at which only the polythiophene block absorbs and thus, the increase of molecular weight after its copolymerization is clearly shown. The corresponding molecular weight values of **Copolymer 1** and of the initial *ω*- terminated end vinyl regioregular poly(3-octyl thiophene) are given in **Table 1.**

**Table 1: Results of size exclusion chromatography for the Random Copolymer 1, m=23, x=1.5, y=98.5, R1=perfluorophenyl, R2=H, R3=C₈H₁₇ in comparison with the initial ω-end vinyl regioregular poly(3- octyl thiophene), m=23, both detected at 440nm.**

| | **Copolymer 1 (440nm)** | ***ω*-end vinyl regioregular poly(3-octyl thiophene) (440nm)** |
|---|---|---|
| **Mn** | 7000 | 4560 |
| **Mw** | 13500 | 5900 |
| **Mw/Mn** | 1,9 | 1,3 |

The rate of the individual polymers in the final copolymer is calculated using the nuclear magnetic resonance spectroscopy (NMR) from the ratio of the peaks corresponding to the methylene protons attached to the core of thiophene and the peak of the protons of the quinoline ring. An indicative example is shown in **Figure 2** for **Copolymer 1.** The fluorescence spectra of **Copolymer 1** are shown in **Figure 3****.** The hybrid copolymeric materials described in the present invention relate to carbon allotropes such as fullerenes or carbon nanotubes bearing copolymers of modified poly(vinyl quinoline)s and of regioregular poly (3-alkyl thiophenes) or terthiophenes. The present invention provides the following embodiments for the synthesis of hybrid materials was performed:
(1) by reacting azide modified, at different rates, poly(perfluoro phenyl quinoline) or poly(fluorophenyl quinoline) homopolymers or copolymers of the above, with fullerenes or carbon nanotubes (for example **Hybrid electron acceptors 3** (included by way of reference only), Hybrid **donor-acceptor copolymers 4a, 4b**).
(II) by employing phenyl-chloropropionyl modified carbon allotropes (fullerenes, carbon nanotubes, graphenes) for the ATRP copolymerization of ***R1*** substituted vinyl-phenyl quinolines and of *ω*- terminated end vinyl regioregular poly(3-alkyl thiophene)s or vinyl terthiophenes (for example **Hybrid Donor-Acceptor Copolymers 4c**).
(III) by reacting phenyl-amine or phenyl-chloropropionyl or tetrafluorophenyl-azide *ω-*end terminated regioregular poly(3-alkyl thiophene)s or terthiophenes, with the **Hybrid polymeric materials 3** producing **Hybrid Donor-Acceptor Copolymers 4d.**

The hybrid materials were characterized by optical spectroscopic techniques such as ultraviolet-visible absorption spectroscopy and an example of the absorption spectra of the **Hybrid electron acceptor 3** (included by way of reference only) in chloroform solution compared to the initial polymeric precursors poly[2-(perfluorophenyl)-4-phenyl-6-(4-vinylphenyl)quinoline], poly[2-(4-azido-2,3,5,6-tetrafluorophenyl)-4-phenyl-6-(4-vinylphenyl)quinoline] and fullerene (C₆₀) is shown in **Figure 4** showing absorption peaks at 260nm, and 330nm. Thermogravimetric analysis (TGA) was also used for the characterization of the hybrid electron acceptors and an example for the **Hybrid electron acceptor 3** (included by way of reference only) is shown in **Figure 5****,** where the percentage weight loss of the hybrid material is in correspondence with the proposed structure. Similar experiments were performed for **Hybrid acceptors 4** and an example of the TGA analysis for the **Hybrid acceptors 4c** is shown in **Figure 6** for the material based on single wall carbon nanotubes modified with substituted quinolines.

A detailed characterization of the energy levels of the hybrid materials was performed by using ultraviolet photoelectron spectroscopy (UPS) which is shown in **Figures 7** and **8** for the **Hybrid acceptors 3** (included by way of reference only) and **4c.** As it is shown in these spectra, the coupling of different semiconducting segments on fullerenes or carbon nanotubes, in addition to the expected and anticipated solubility increase, also affects the energy levels of the final hybrid material. Finally, blends of the various hybrid materials with regioregular poly(3-alkyl thiophene)s have been studied showing promising behaviors which indicate their applicability in plastic photovoltaics.

Accordingly, the present invention provides hybrid materials comprised of carbon allotrope forms, optionally fullerenes or single wall carbon nanotubes, and copolymeric materials comprising polythiophenes with electron donating properties and polyquinolines with electron accepting properties, wherein the copolymers have the architecture of the random copolymer 1 or of the rod-coil block copolymer 2a, or of the coil-coil block copolymer 2b, or of the brush type rod-coil copolymer 2c.

Hybrid materials comprised of carbon allotrope forms, optionally fullerenes or single wall carbon nanotubes, and copolymeric materials comprising polythiophenes with electron donating properties and polyquinolines with electron accepting properties, wherein the copolymers have the architecture of the random copolymer 1 or of the rod-coil block copolymer 2a, or of the coil-coil block copolymer 2b, or of the brush type rod-coil copolymer 2c.

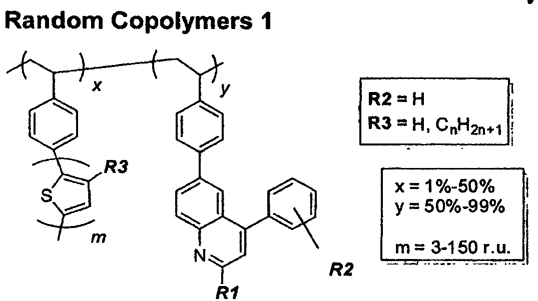

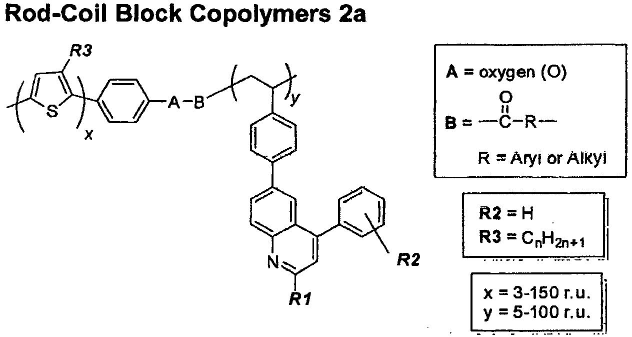

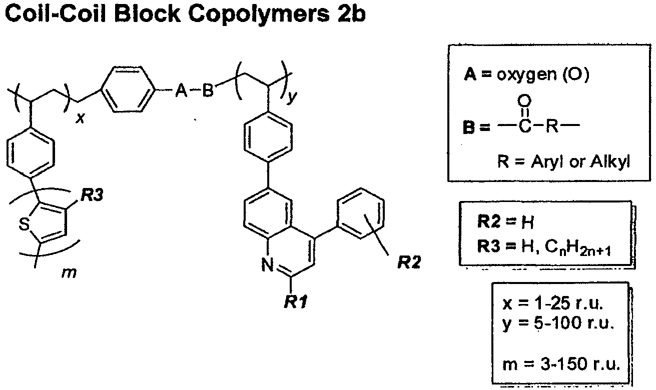

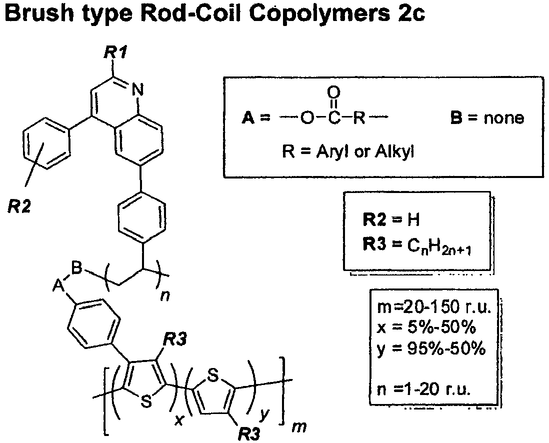

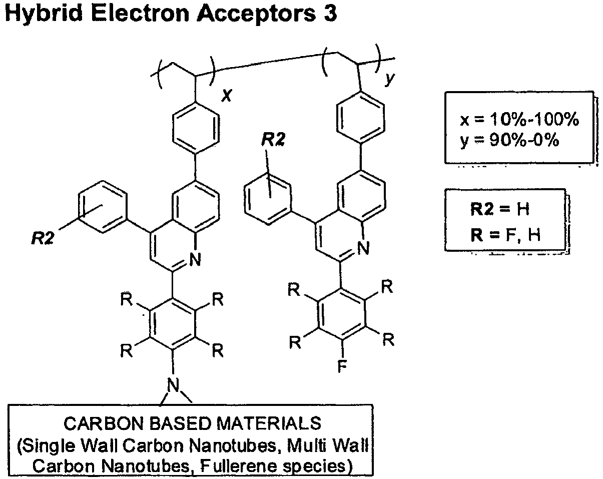

In a preferred embodiment, the hybrid materials comprise compounds of the formulae:

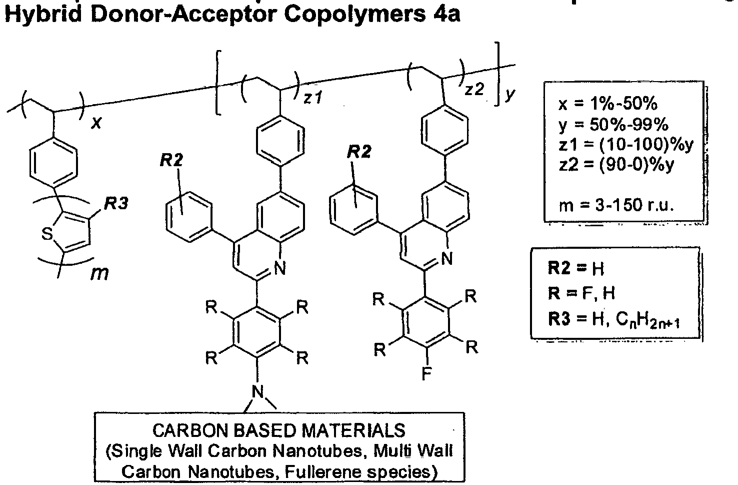

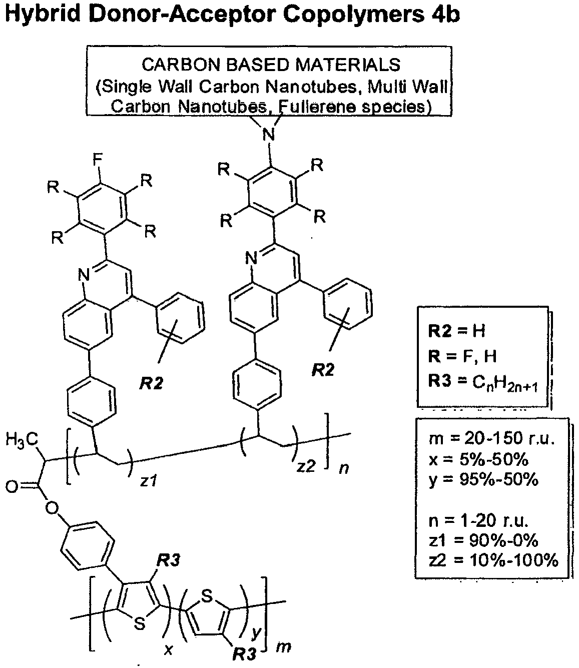

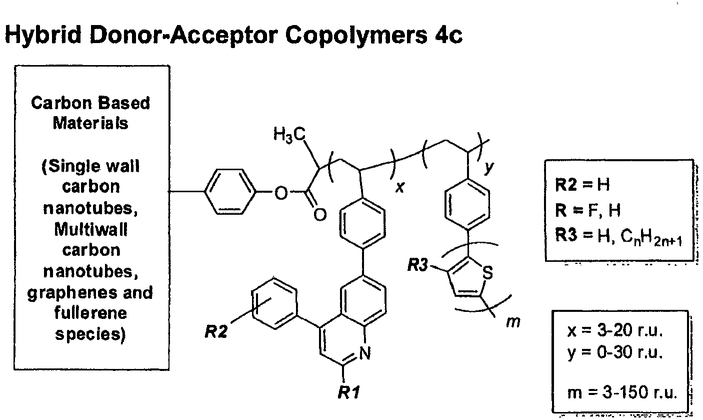

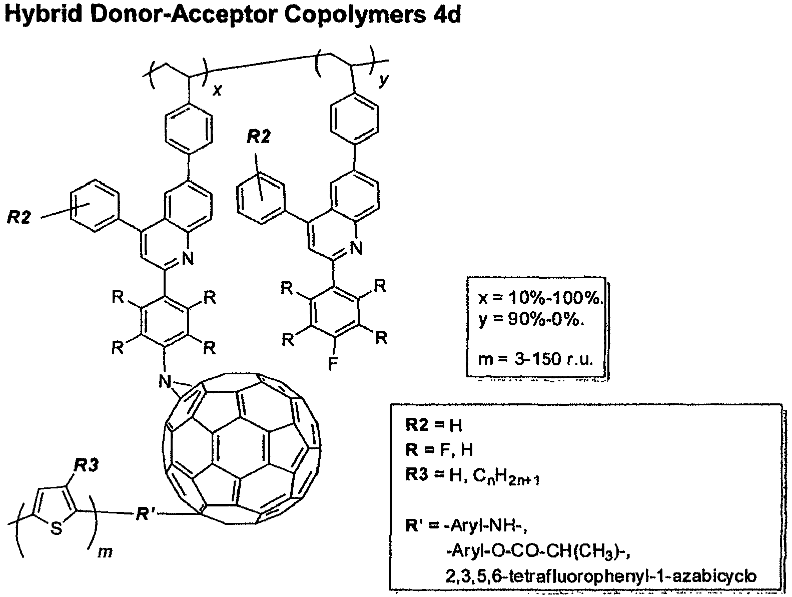

In the above formulae "r.u." stands for repeating unit.

Additionally, for the ease of representation, where the above formulae show the relative percentages of particular monomers this is in a schematic manner rather than an exact structural representation, e.g. for Random Copolymer 1 the above formula represents a polymer comprising 1 to 50% of the total monomers being x and 50 to 99% of the total monomers being y rather than a block of monomer x attached to a block of monomer y. Correspondingly where, for example, the x and y monomers are displayed in terms of r.u., the above formulae display the blocks present. In an embodiment of the present invention, these blocks can constitute the whole polymer or repeating units within the polymer.

Preferred embodiments of each of the above polymers are discussed below:

### Random Copolymer 1

In a preferred embodiment of the present invention x= 1%-40% and most preferably 2%-35%.

In a preferred embodiment of the present invention y= 60%-99% and most preferably 65%-98%.

In a preferred embodiment of the present invention m=3-80 r.u. and most preferably 3-30 r.u.

In a preferred embodiment of the present invention x=2%-35%, y=65%-98% and m=3-30 r.u.

### Rod-Coil Block Copolymer 2a

In a preferred embodiment of the present invention x= 5-100 r.u. and most preferably 5-30 r.u.

In a preferred embodiment of the present invention y=10-50 r.u. and most preferably 15-45 r.u.

In a preferred embodiment of the present invention x =5-30 r.u. and y=15-45 r.u.

### Coil-Coil Block Copolymer 2b

In a preferred embodiment of the present invention x=1-10 r.u. and most preferably 3-8 r.u.

In a preferred embodiment of the present invention y=10-50 r.u. and most preferably 15-45 r.u.

In a preferred embodiment of the present invention m=3-80 r.u. and most preferably 3-30 r. u.

In a preferred embodiment of the present invention x=3-8 r.u., y=15-45 r.u. and m=3-30 r.u.

### Rod-coil Brush type copolymer 2c

In a preferred embodiment of the present invention m=20-100 r.u. and most preferably 30-60 r.u.

In a preferred embodiment of the present invention x=10%-35% and most preferably 20%-30%.

In a preferred embodiment of the present invention y= 90%-65% and most preferably 80%-70%.

In a preferred embodiment of the present invention n= 5-15 and most preferably 5-10.

In a preferred embodiment of the present invention m=30-60 r.u., x=20%-30%, y=80%-70% and n=5-10.

### Hybrid Electron Acceptors 3 (included by way of reference only)

In a reference embodiment x=30%-80% and most preferably 35%-60%.

In a reference embodiment y=70%-20% and most preferably 65%-40%.

In a reference embodiment x=35%-60% and y=65%-40%.

### Hybrid Donor-Acceptor Copolymers 4a

In a preferred embodiment of the present invention x=1%-40% and most preferably 2%-35%.

In a preferred embodiment of the present invention y=60%-99% and most preferably 65%-98%.

In a preferred embodiment of the present invention z1=(30-80)%y and most preferably (35-60)%y.

In a preferred embodiment of the present invention z2 =(70-20)%y and most preferably (65-40)%y.

In a preferred embodiment of the present invention m=3-80 r.u. and most preferably 3-30 r.u.

In a preferred embodiment of the present invention x=2%-35%, y=65%-98%, z1=(35-60)%y, z2=(65-40)%y and m=3-30 r.u.

### Hybrid Donor-Acceptor Copolymers 4b

In a preferred embodiment of the present invention m=20-100 r.u. and most preferably 30-60 r.u.

In a preferred embodiment of the present invention x=10%-35% and most preferably 20%-30%.

In a preferred embodiment of the present invention y=90%-65% and most preferably 80%-70%.

In a preferred embodiment of the present invention n=5-15 r.u.and most preferably 5-10 r.u.

In a preferred embodiment of the present invention z1=(70-20)%y and most preferably (65-40)%y.

In a preferred embodiment of the present invention z2=(30-80)%y and most preferably (35-60)%y.

In a preferred embodiment of the present invention x=20%-30%, y=80%-70%, z1(65-40)%y, z2(35-60)%y, n=5-10 r.u. and m=30-60 r.u.

### Hybrid Donor-Acceptor Copolymers 4c

In a preferred embodiment of the present invention x=4-15 r.u. and most preferably 5-10 r.u.

In a preferred embodiment of the present invention y=0-10 r.u. and most preferably 0-5 r.u.

In a preferred embodiment of the present invention m=3-80 r.u. and most preferably 3-30 r.u.

In a preferred embodiment of the present invention x=5-10 r.u., y=0-5 r.u. and m=3-30 r.u.

### Hybrid Donor-Acceptor Copolymers 4d

In a preferred embodiment of the present invention m=3-80 r.u. and most preferably 3-30 r.u.

In a preferred embodiment of the present invention x=30%-80% and most preferably 35%-60%.

In a preferred embodiment of the present invention y=70%-20% and most preferably 65%-40%.

In a preferred embodiment of the present invention x=35%-60%, y=65%-40% and m=3-30 r.u.

In preferred embodiments of the present invention, in the above chemical formulae, R1 is an electron withdrawing group, preferably selected from the group consisting of a substituted phenyl group, a pyridyl group, a carbonyl group, a nitro group, a cyano group, a fluorine, preferably a substituted phenyl group or pyridyl, wherein the phenyl group is substituted with between 1 and 6 substituents selected from a nitro group, a cyano group, a fluorine, preferably R1 is a perfluorphenyl group, a pyridyl group or a cyano group.

In preferred embodiments of the present invention, in the above chemical formulae, R2 is hydrogen.

In preferred embodiments of the present invention in the above chemical formulae R3 is selected from the group consisting of hydrogen, C1 to C20 alkyl group, preferably a C4 to C10 alkyl group, more preferably a C6 to C8 alkyl group and most preferably a C6 or a C8 alkyl group.

In preferred embodiments of the present invention R in the definitions of groups A and B is a C1 to C20 alkyl group, preferably a C2 to C4, most preferably C2 alkyl group, or an aryl group, preferably a C6 to a C10 aryl group.

In preferred embodiments of the present invention R in the hybrid compounds is fluorine or hydrogen.

In preferred embodiments of the present invention R' is selected from the group consisting of -aryl-NH-, -aryl-O-CO-CH(CH₃)-, or 2,3,5,6,-tetrafluorophenyl-1-azabicyclo, where the aryl group is preferably a C6 to a C10 aryl group.

In preferred embodiments of the present invention the carbon based materials are fullerenes or carbon nanotubes, preferred embodiments here are C₆₀, C₇₀ or PCBM ([6,6]-Phenyl C₆₁ butyric acid methyl ester), most preferably PCBM, and multi, single or short single wall carbon nanotubes and most preferably short single wall carbon nanotubes.

In an embodiment of the present invention the above copolymers and/or hybrid copolymers are blended with polymers having electron donor properties. In a preferred embodiment the copolymer or hybrid material are present at an amount of 10%wt and up to 90%wt of the blend, optionally 20%wt to 80%wt. In a preferred embodiment the polymers having electron donor properties make up the rest of the blend. In a preferred embodiment the polymer present in the blend is a polythiophene, preferably regioregular poly(3-alkyl-thiophene) and more preferably regioregular poly(3-hexyl thiophene) or regioregular poly(3-octyl thiophene).

The present invention also provides a photovoltaic device where the active layer of the device comprises the compounds of the present invention. The other features of the photovoltaic device are known in the art. In an embodiment of the present invention the active layer further comprise electron donor polymers, optionally polythiophenes, preferably regioregular poly(3-alkyl-thiophene) and more preferably regioregular poly(3-hexyl thiophene) or regioregular poly(3-octyl thiophene).

In an embodiment of the present invention provided is a photovoltaic device comprising the hybrid materials described above and blends of polythiophenes and fullerene derivatives in the active layer of the device. In this embodiment, preferably the polythiophenes are regioregular poly(3-hexyl thiophene) or regioregular poly(3-octyl thiophene) and the fullerenes are C₆₀, C₇₀ or PCBM ([6,6]-Phenyl C₆₁ butyric acid methyl ester), most preferably PCBM.

In an embodiment of the present invention, in the above numerical ranges, unless otherwise specified, the end points recited are included in the range.

### Examples

### Characterization techniques

Size exclusion chromatography (GPC) is used for the calculation of molecular weight (Mn and Mw) and dispersion of the polymers.

Nuclear magnetic resonance spectroscopy (NMR) is used to certify the chemical and molecular structure of polymers and the ratio of monomers in copolymers.

Infrared Spectroscopy (FT-IR) is used, complementary to NMR spectroscopy, to identify the chemical and molecular structure of polymers.

Thermogravimetric analysis (TGA) is used to study the thermal and oxidative stability of the copolymers and hybrid copolymers.

The photoemission experiments were carried out in an ultra-high-vacuum system, which consists of analysis chamber with a base pressure <5 X 10⁻¹⁰ mbar. The system is equipped with a hemispherical electron energy analyzer (SPECS LH-10) and a UV lamp for UPS measurements. UPS spectra were recorded with HeI (hv=2.123eV).

UV-Vis spectra were recorded using a Hewlett Packard 8452A Diode Array.

UV-Vis-NIR characterization was conducted on a Perkin Elmer L 900 spectrometer.

Continuous wave photoluminescence was measured on a Perkin Elmer LS45 spectrofluorometer.

All of the above polymeric and hybrid materials were studied and characterized by several techniques to confirm that can be used as semiconducting materials with electron accepting or both electron donating and accepting properties in organic photovoltaic devices.

### Synthesis of materials

### Example 1:

### Synthesis of random Copolymer 1, m=3, x=33.3, y=66.7 and R3=H, R1=perfluoro-phenyl, R2=H

6-(4-vinylphenyl)-2-perfluorophenyl-4-phenyl quinoline (135.18mg, 0.2858mmol), 2-(5-(thiophene-2-yl)thiophen-2-yl)-5-(4-vinylphenyl)thiophene (50mg, 0.1429mmol), azoisobutyronitrile (4.69mg, 0.0285mmol) and distilled tetrahydrofuran (5mL) were added to a degassed flask equipped with condenser. The mixture was degassed, filled with argon and then refluxed for 48 hours. After cooling to room temperature the viscous mixture was precipitated in methanol and the solid was filtered and washed with methanol. The final polymer was dried at 60 °C under high vacuum for 24 hours.

### Example 2:

### Synthesis of Copolymer 2b, m=60, x=10, y=20 and R3=C₈H₁₇, R1=pyridine, R2=H

6-(4-Vinylphenyl)-2-(2-pyridine)-4-phenyl-quinoline (300mg, 0.781 mmol), copper bromide (5.59mg, 0.0391mmol), 2.2'-bipyridine (12.184mg, 0.0781mmol) and distilled *N*,*N* dimethylformamide were added to a degassed flask. The reaction mixture was degassed, filled with argon and then stirred for 30 minuters at 25 °C. Then a solution of methyl-4-(bromomethyl) benzoate (8.948mg, 0.0391mmol) in distilled *N,N* dimethylformamide (1mL) was added in the mixture and the mixture was heated under argon at 110 °C for 48 hours. After cooling to room temperature the viscous mixture was precipitated in methanol and the solid was filtered, washed with methanol and the final polymer was dried at 60°C under high vacuum for 24 hours. The hydrolysis of α-end methyl ester was carried out in a mixture of tetrahydrofuran (30mL) and aqueous potassium hydroxide 10N (5mL) at 60 °C C for 24 hours. The final α-carboxy polymer was obtained after precipitation into methanol, filtration, washing with water, methanol and hexane and dried at 40 °C under high vacuum for 24 hours. The conversion of α-carboxy to α-carbonyl chloride was performed by heating the polymer in thionyl chloride (10mL) in the presence of triethylamine (2mL). *ω*-Vinyl-regioregular poly(3-octyl-thiophene) (Jeffries-El, M.; Sauvé, G.; McCullough, R. D. Adv. Mater. 2004, *16*, 1017) (200mg), copper bromide (2.46mg, 0.0172mmol), 2.2'-bipyridine (5.37mg, 0.0344mmol) and distilled *N,N* dimethylformamide (2mL) were added in a degassed flask. The mixture was degassed, filled with argon and then stirred at 25 °C for 30 minutes. Then 4 - (bromomethyl) acetoxy phenylene (0,39mg, 0,0017mmol) in distilled *N,N* dimethylformamide (1mL) was added in the flask and the mixture was heated under argon at 110 °C for 48 hours. After cooling to room temperature the mixture was precipitated in methanol and the solid that resulted was filtered, washed with methanol and the final polymer dried at 60 °C under high vacuum for 24 hours. The hydrolysis of end α- acetyl group was performed in a mixture of tetrahydrofuran (30mL) / aqueous potassium hydroxide 10N (5mL) at 60 °C for 24 hours.

Then the end α-hydroxyl phenyl-poly(vinyl-regioregular poly(3-octyl-thiophene) was condensed with the poly(6-(4-vinylphenyl)-2-(2-pyridine)-4-phenyl-quinoline) which is bearing an end α-carbonyl chloride in distilled 1,1,2,2-tetrachloroethane (5mL) and triethylamine (0,5 mL) at 120 °C for 48 hours. The final copolymer was obtained after precipitation in methanol, filtration washing with methanol and drying under high vacuum for 24 hours.

### Reference Example 3

### Synthesis of Hybrid electron acceptors 3 (included by way of reference only), x=50, y=50, R2=H, R=F and fullerene (C₆₀) as carbon allotrope form.

Poly[6-(4-vinylphenyl)-2-perfluorophenyl-4-phenyl-quinoline)] (A. A. Stefopoulos, S. N. Kourkouli, S. Economopoulos, F. Ravani, A. Andreopoulou, K. Papagelis, A. Siokou, J. K. Kallitsis Macromolecules, 2010, 43, 4827) (400mg), NaN₃ (27,484mg, 0,423mmol) and *N,N* dimethylformamide (50mL) were added to a degassed flask. The mixture was degassed, filled with argon and then stirred at 25 °C for 24 hours. The mixture was precipitated in deionized water, washed with methanol and hexane and then dried under high vacuum for 24 hours at 30 °C. The resulting polymer, fullerene C₆₀ (365,66mg, 0,5074mmol) and o-dichlorobenzene (30mL) were added to a degassed flask equipped with condenser. The mixture was degassed, filled with argon and then it was stirred at 130 °C for 3 days in the absence of light. Then, the solvent was removed and the obtained solid was purified by Soxhlet extraction with hexane solvent for the removal of the excess of fullerene and with chloroform for the dissolving of the final **Hybrid electron acceptor 3** (included by way of reference only). The solution of the **Hybrid electron acceptor 3** (included by way of reference only) was concentrated and the final product was dried under high vacuum at 30 °C.

The above procedure was followed for the synthesis of **Hybrid donor-acceptor Copolymers 4a, 4b** with various percentages of fullerenes.

### Example 4

### Synthesis of Hybrid electron donor-acceptor Copolymers 4c, x=5 y=0, R2=H, R1=cyano-phenyl and single wall carbon nanotubes as carbon allotrope form

Single wall carbon nanotubes (100mg, 8.33meq C), p-aminophenol (1g, 9.17mmol) and isopentyl nitrite ester (3mL) were added in a degassed flask. The flask was degassed and filled with argon, while the whole system was covered with aluminum foil to protect it from day light. The reaction mixture was then heated at 70 °C for 36 hours. Then the mixture was filtrated from filters (PTFE 0.22mm) and the black solid product was collected. The solid product is washed with acetone and *N*,*N-*dimethylformamide and then it is dried at 60 °C for 24 hours (affording the hydroxyl-functionalized SWCNTs, SWCNT-Ph-OH).

Further, 25mg of SWCNT-Ph-OH and 25mL of distilled *N,N* dimethylformamide were placed in a flask of 50mL. The suspension was sonicated for about 20 minutes. Then it was cooled in an ice bath and triethylamine (50µL) and chloropropionyl chloride (100µL) were added under an argon atmosphere. Then the mixture was heated at reflux for 48h. After cooling to room temperature the mixture is then filtrated using PTFE filters of 0.22mm and the black solid product is collected. The product is washed with *N,N* dimethylformamide and dichloromethane and then is dried under vacuum at 60 °C for 24 hours (affording the initiator functionalized SWCNTs, SWCNT-Ph-Init).

Further, SWNT-Ph-Init (20mg) and distilled *N,N* dimethylformamide (5mL) are placed in a flask of 10mL and then the mixture is degassed and filled with argon several times. Then it is sonicated for about 20 minutes. Subsequently, copper bromide (0.01mmol), 2,2'-bipyridine (0.01mmol) and 6-(4-vinylphenyl)-2-cyano-4-phenylquinoline (1 mmol) were added in the flask and the flask was degassed and filled with argon again. The flask with the reaction mixture was heated at 110 °C for 24 hours. Then, the mixture was allowed to cool to room temperature, filtrated from a 0.2mm PTFE membrane filter and the obtained solid was washed with acetone, *N,N* dimethylformamide, tetrahydrofuran and chloroform. The final black solid was dried under vacuum at 60 °C for 24 hours, affording the **Hybrid electron donor-acceptor Copolymers 4c.**

## Claims

1. Hybrid materials comprised of carbon allotrope forms, optionally fullerenes or single wall carbon nanotubes, and copolymeric materials comprising polythiophenes with electron donating properties and polyquinolines with electron accepting properties, wherein the copolymers have the architecture of the random copolymer 1 or of the rod-coil block copolymer 2a, or of the coil-coil block copolymer 2b, or of the brush type rod-coil copolymer 2c.

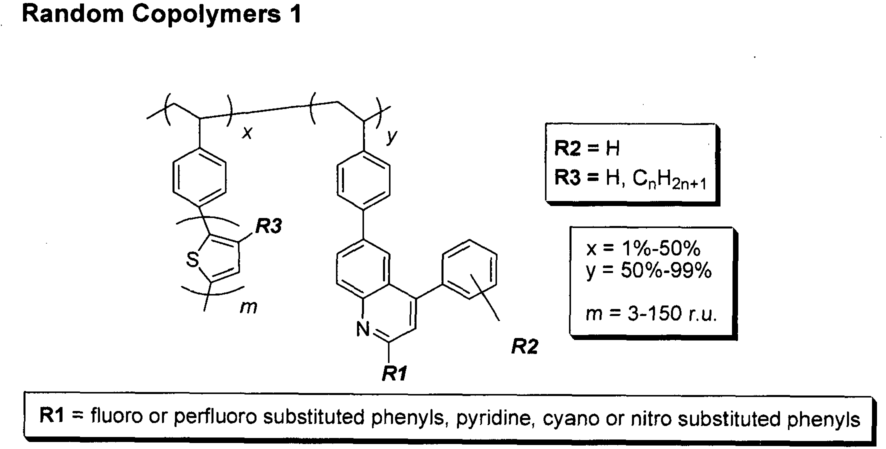

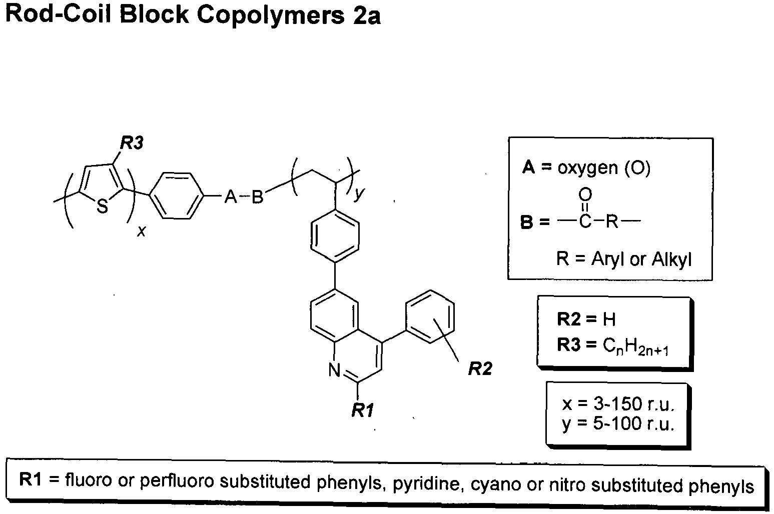

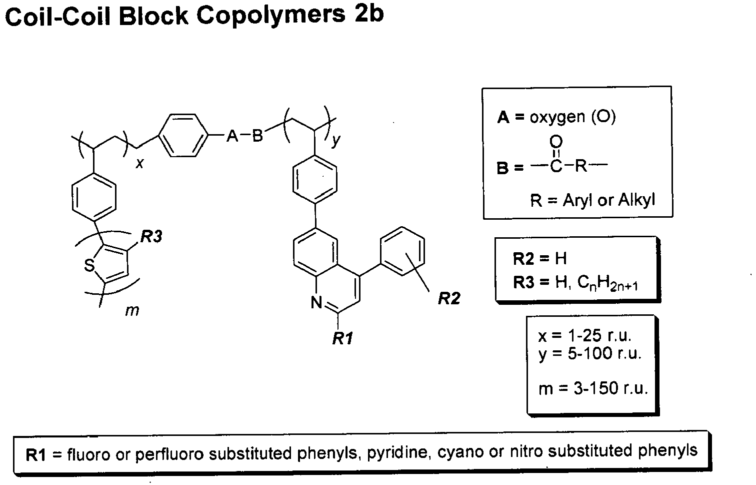

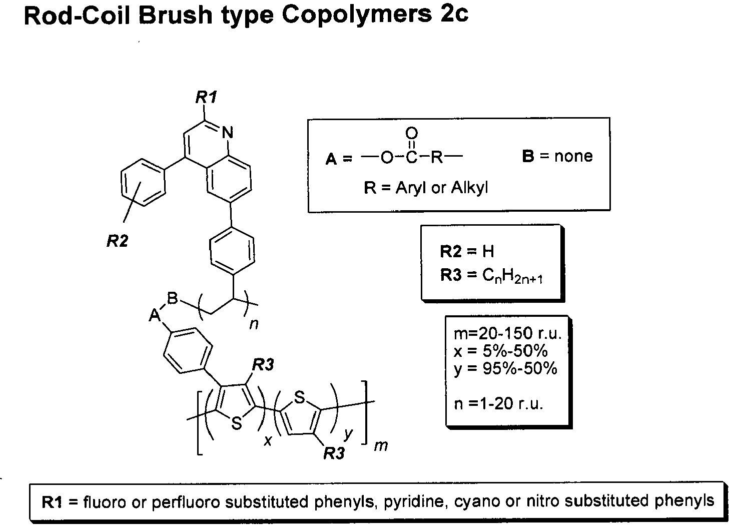

2. Hybrid materials of claim 1, comprising compounds of formulae:

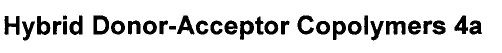

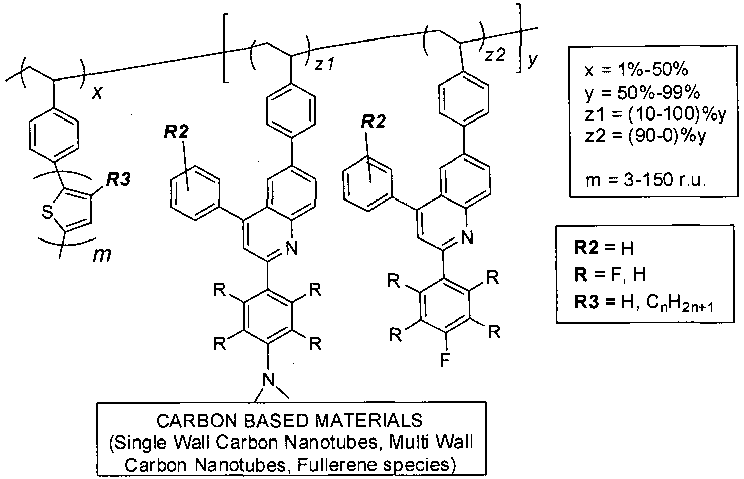

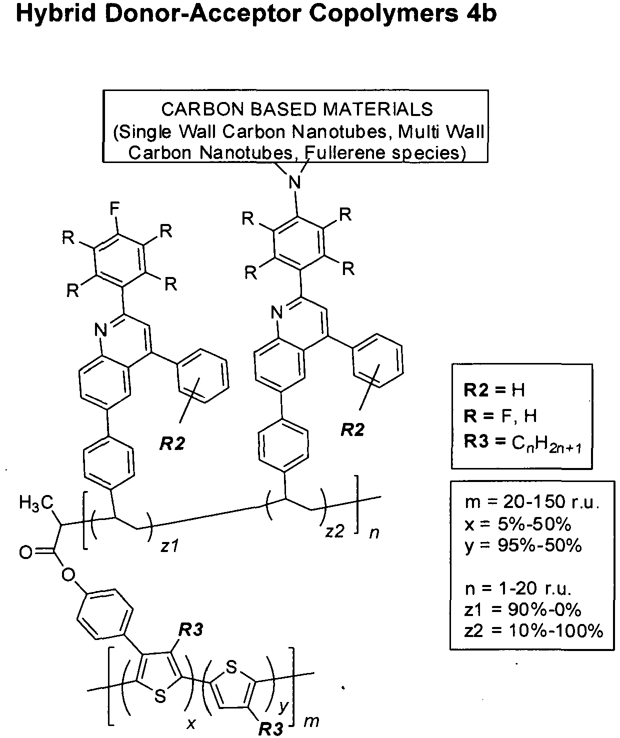

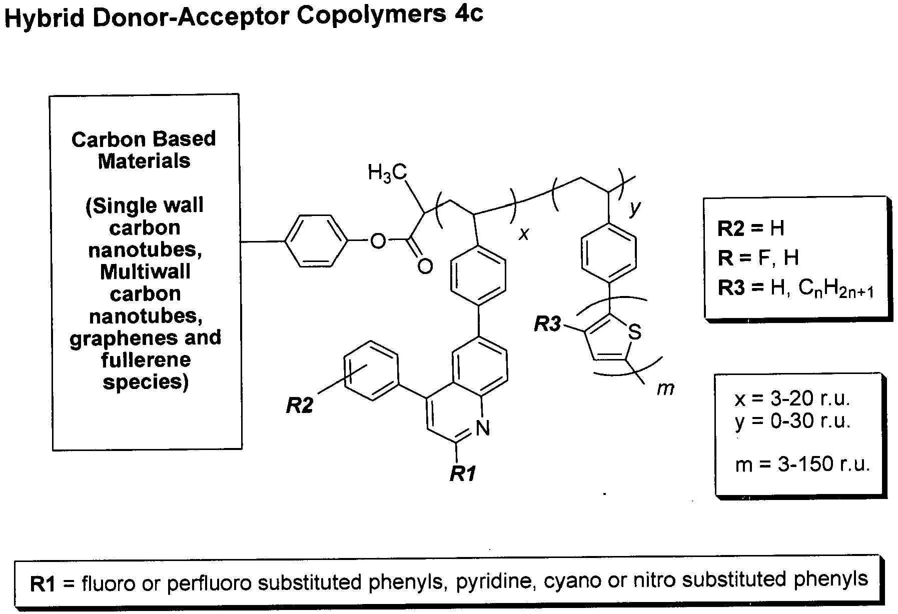

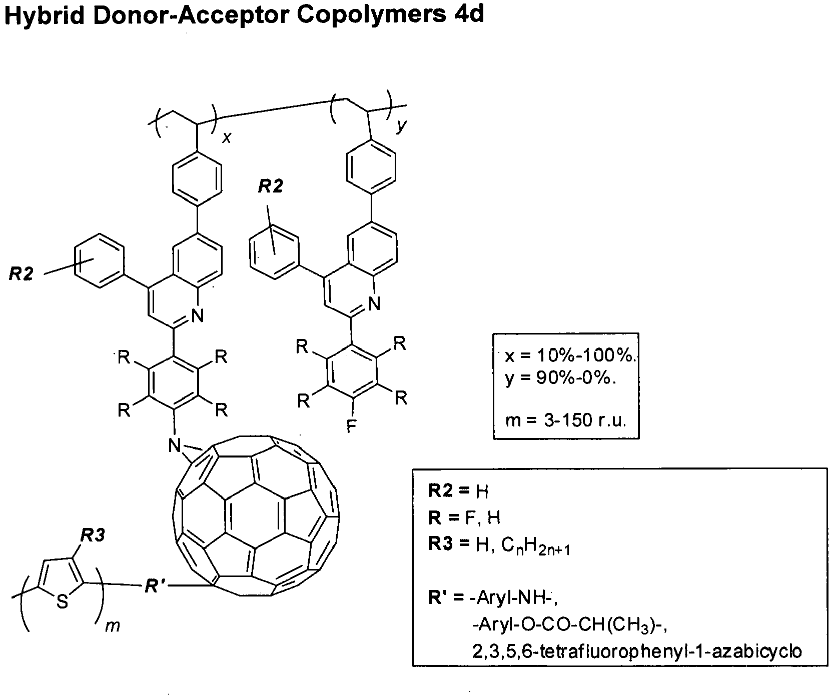

3. A composition comprising the hybrid materials of claim 1 with polymers having electron donor properties, optionally polythiophenes, at which the copolymer is in a range 10%wt and up to 90%wt in the blend.

4. A composition comprising the hybrid materials of any of claims 1 to 2 with polymers having electron donor properties, optionally polythiophenes, at which the hybrid material is in a 10%wt and up to 90%wt in the blend.

5. A photovoltaic device comprising the hybrid materials of claim 1 in the active layer of the device.

6. The Photovoltaic device of claim 5, wherein the active layer further comprises electron donor polymers, optionally polythiophenes, or small organic molecules.

7. A photovoltaic device comprising the hybrid materials of any of claims 1 to 2 and blends of polythiophenes and fullerene derivatives in the active layer of the device.

## Patentansprüche

1. Hybridmaterialien aus Kohlenstoff-Allotrop-Formen, gegebenenfalls Fullerenen oder einwandigen Kohlenstoff-Nanoröhren und Copolymer-Materialien, die Polythiophene mit Elektronen-Donor Eigenschaften und Polychinoline mit Elektronen-Akzeptor Eigenschaften umfassen, wobei die Copolymere die Architektur des Random-Copolymers 1 oder des Rod-Coil Blockcopolymers 2a oder des Coil-Coil Blockcopolymers 2b oder des Rod-Coil Copolymers 2c von Bürstentyp aufweisen.

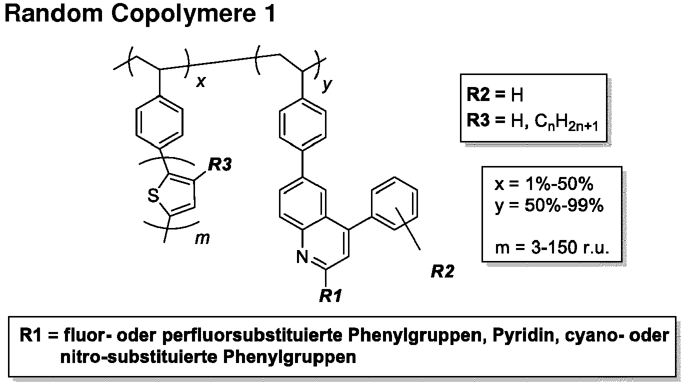

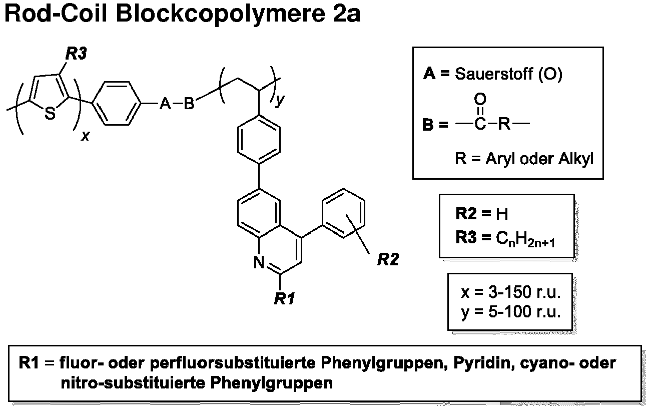

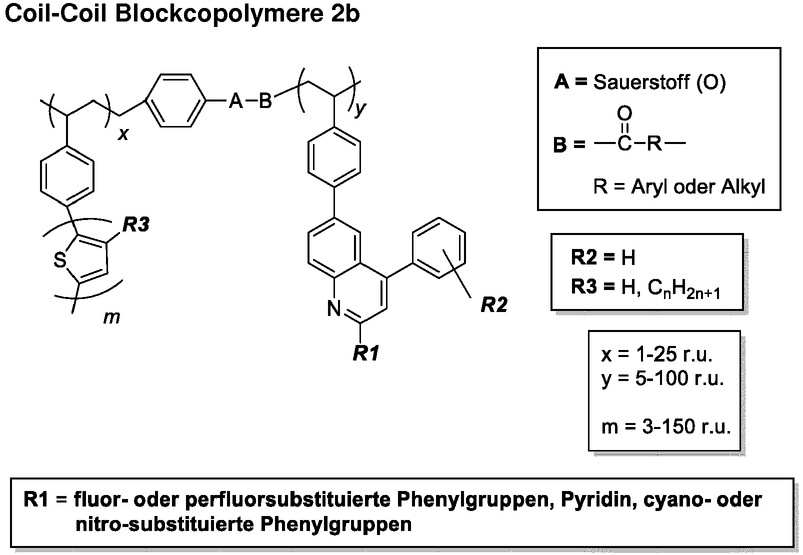

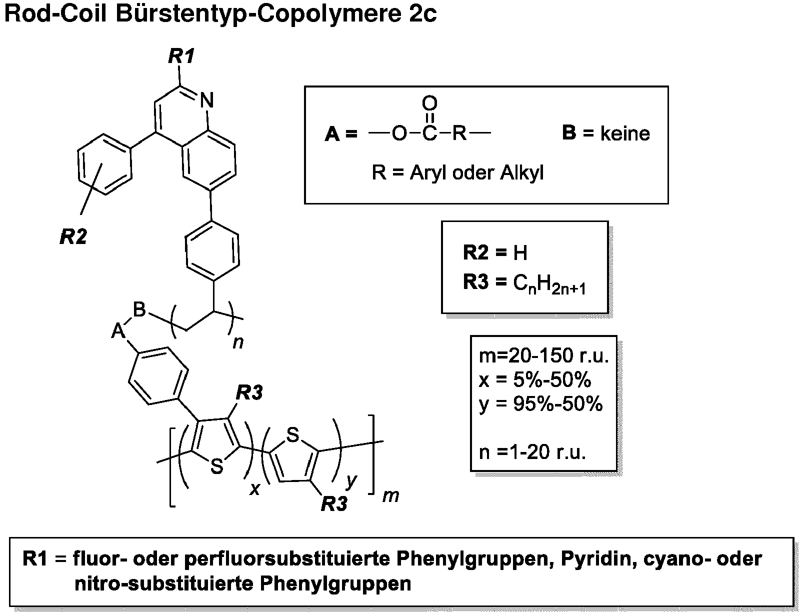

2. Hybridmaterialien nach Anspruch 1, umfassend Verbindungen der Formeln:

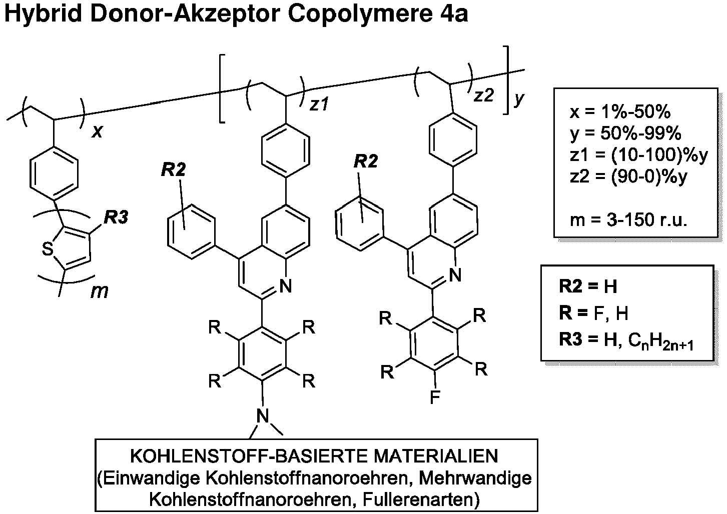

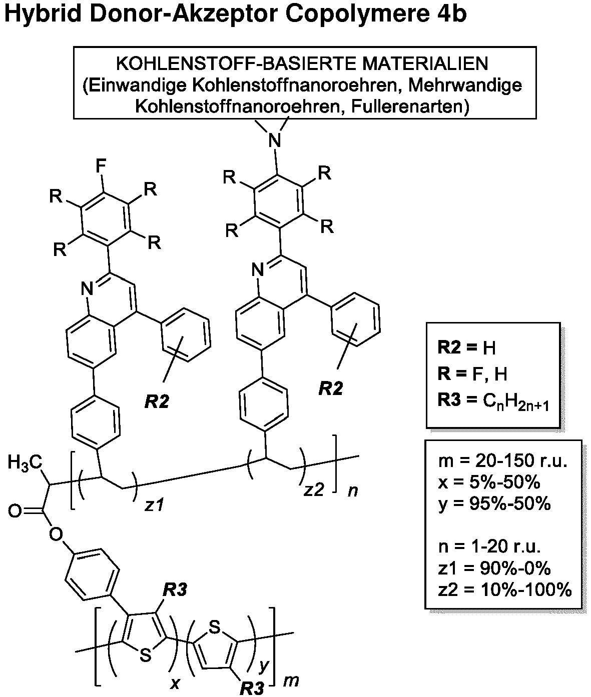

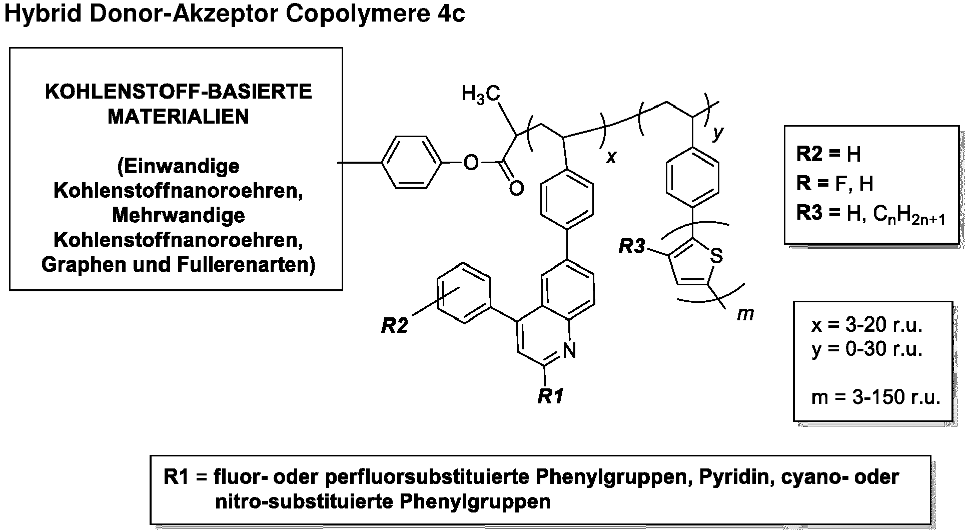

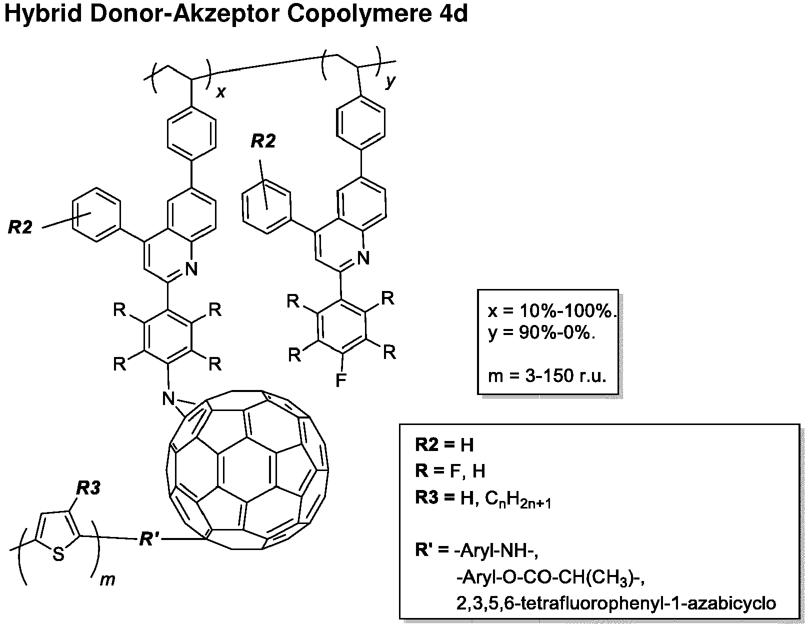

3. Eine Zusammensetzung umfassend die Hybridmaterialien nach Anspruch 1 mit Polymeren die Elektronen-Donor Eigenschaften haben, gegebenenfalls Polythiophenen, wobei das Copolymer in einem Bereich von 10% Gew. und bis zu 90% Gew. in der Mischung vorliegt.

4. Eine Zusammensetzung umfassend die Hybridmaterialien nach einem der Ansprüche 1 bis 2 mit Polymeren die Elektronen-Donor Eigenschaften haben, gegebenenfalls Polythiophenen, wobei das Hybridmaterial in einem Bereich von 10% Gew. und bis zu 90% Gew. in der Mischung vorliegt.

5. Eine Photovoltaikanlage mit den Hybridmaterialien nach Anspruch 1 in der aktiven Schicht der Anlage.

6. Eine Photovoltaikanlage nach Anspruch 5, **dadurch gekennzeichnet, dass** die aktive Schicht weiterhin Elektronen-Donor Polymere, gegebenenfalls Polythiophene oder kleine organische Moleküle umfasst.

7. Eine Photovoltaikanlage mit den Hybridmaterialien nach einem der Ansprüche 1 bis 2 und Mischungen von Polythiophenen und Fullerenderivaten in der aktiven Schicht der Vorrichtung

## Revendications

1. Matériaux hybrides constitués de formes allotropes de carbone, éventuellement de fullerènes ou de nanotubes de carbone à paroi unique, et de matériaux copolymères comprenant des polythiophènes ayant des propriétés donneur d'électrons et des polyquinolines ayant des propriétés d'accepteur d'électrons, les copolymères présentent l'architecture du copolymère statistique 1, ou du copolymère bloc de type ROD-COIL 2a ou du copolymère bloc de type COIL -COIL 2b, ou du copolymère en peigne de type ROD-COIL 2c.

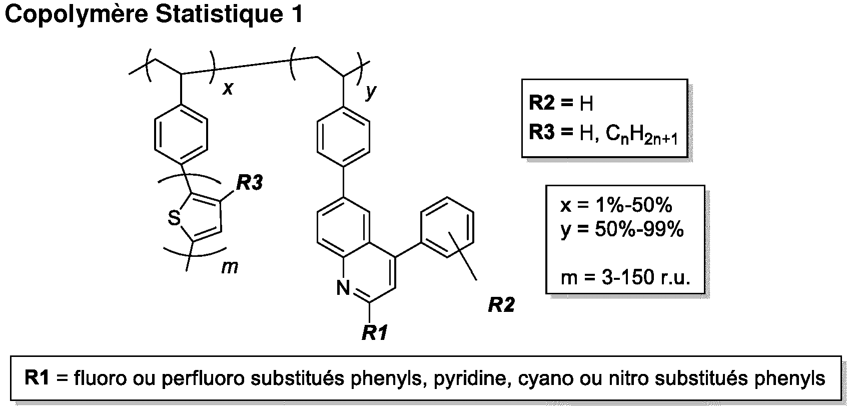

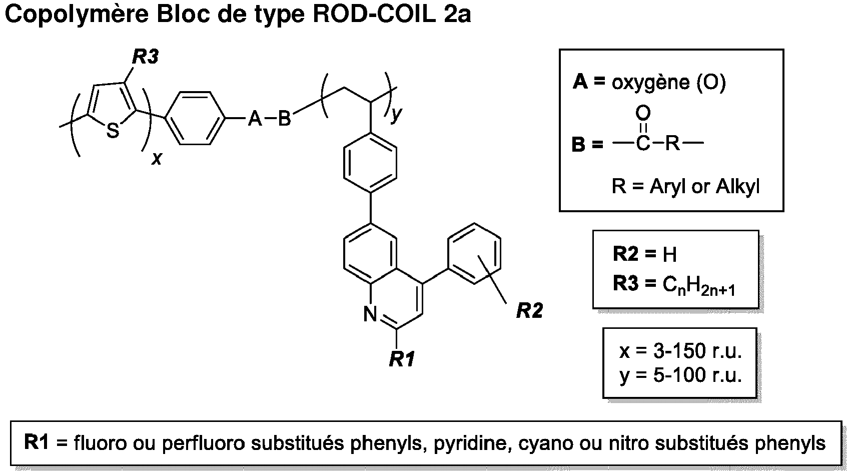

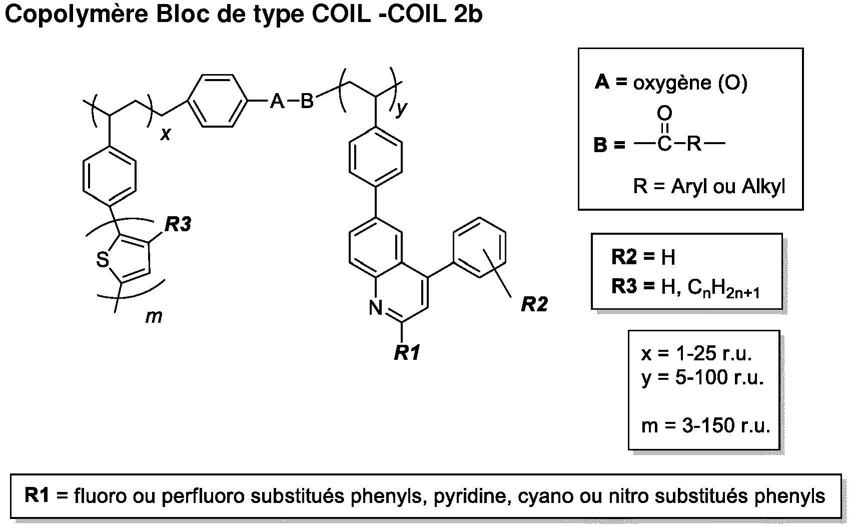

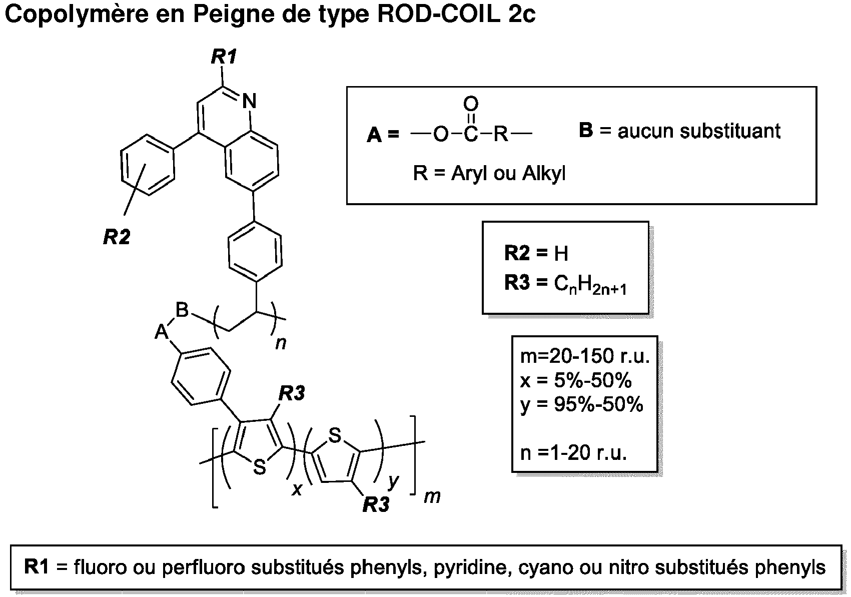

2. Matériaux hybrides selon la revendication 1, comprenant des composés de formules:

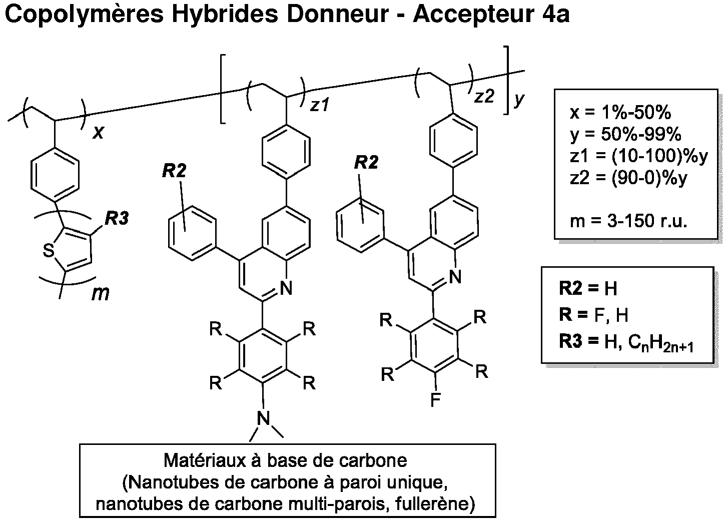

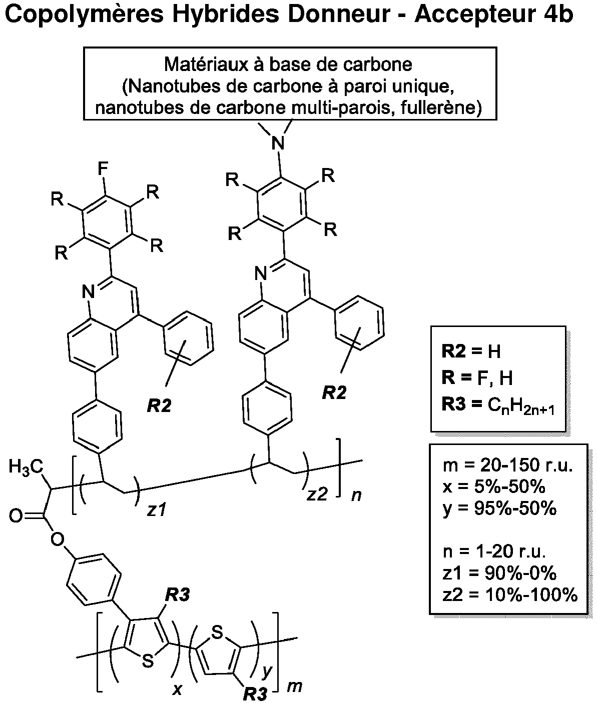

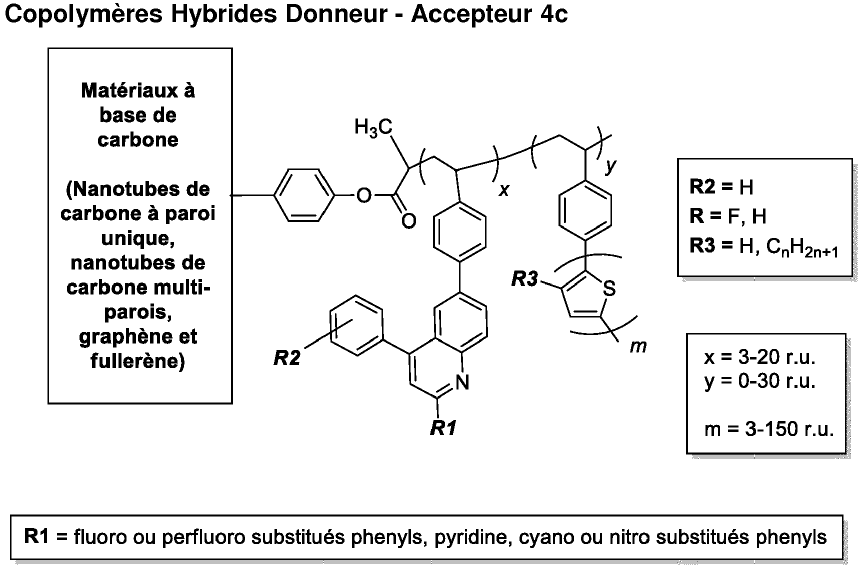

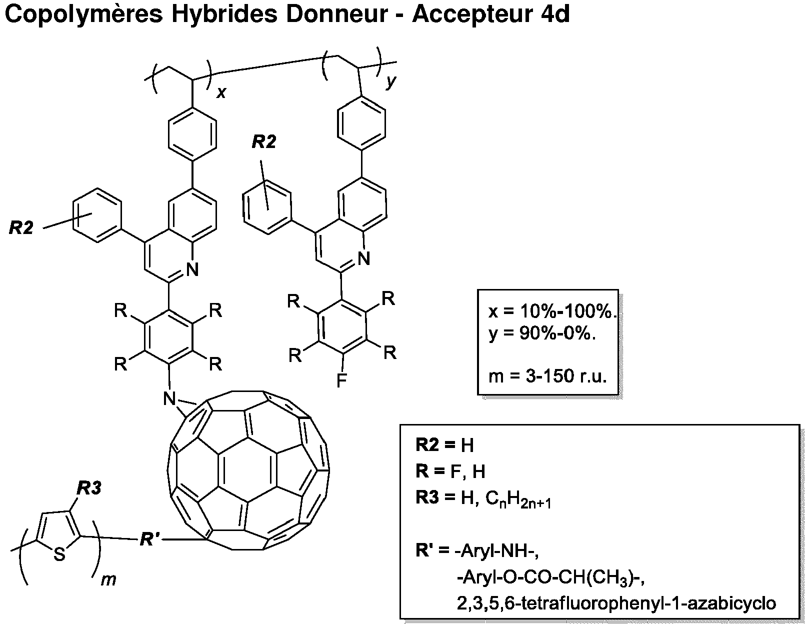

3. Composition comprenant les matériaux hybrides selon la revendication 1, avec des polymères ayant des propriétés donneur d'électrons, éventuellement des polythiophènes, dans laquelle le copolymère représente 10% à 90% du poids total du mélange.

4. Composition comprenant les matériaux hybrides selon chaqu'une des revendications 1 à 2, avec des polymères ayant des propriétés donneur d'électrons, éventuellement des polythiophènes, dans laquelle la matière hybride représente 10% à 90% du poids total du mélange.

5. Un appareil photovoltaïque comprenant les matériaux hybrides selon la revendication 1 dans la couche active du dispositif.

6. L'appareil photovoltaïque selon la revendication 5, dans lequel la couche active comprend en outre des polymères donneurs d'électrons, éventuellement des polythiophènes ou de petites molécules organiques.

7. Un appareil photovoltaïque comprenant les matériaux hybrides selon l'une quelconque des revendications 1 à 2 et des mélanges de polythiophènes et de dérivés de fullerène dans la couche active du dispositif.
